Europäisches Patentamt

European Patent Office

Office européen des brevets

(19)

(11) Publication number: **0 124 238**
A2

(12) # EUROPEAN PATENT APPLICATION

(21) Application number: **84301934.0**

(51) Int. Cl.³: **G 06 F 11/00**

(22) Date of filing: **22.03.84**

(30) Priority: **02.05.83 US 490757**

(43) Date of publication of application: **07.11.84**
Bulletin 84/45

(84) Designated Contracting States: **DE FR GB NL**

(71) Applicant: **TEKTRONIX, INC., Tektronix Industrial Park
D/S Y3-121 4900 S.W. Griffith Drive P.O. Box 500,
Beaverton Oregon 97077 (US)**

(72) Inventor: **Boyce, Douglas G, 6805 S.W. Madrid Drive,
Aloha Oregon 97007 (US)**
Inventor: **Jackson, Ronald M, 14670 N.W. Cornell Road,
Portland Oregon 97229 (US)**

(74) Representative: **Wombwell, Francis et al, Potts, Kerr &
Co. 15, Hamilton Square, Birkenhead Merseyside
L41 6BR (GB)**

(54) **Memory-based digital word sequence recognizer.**

(57) A circuit for detecting the presence of a digital information word sequence within a stream of digital information words comprises a memory (34, 36) which is subdivided into memory levels ($A_6$–$A_9$), each memory level having a plurality of memory locations ($A_0$–$A_5$). In a preferred embodiment, each memory level corresponds to the position of a word in the word sequence and the memory locations store a recognition status word corresponding to the bit pattern or patterns sought to be detected. The memory architecture of the present invention facilitates the detection of long sequences of digital words with the use of relatively few memory devices.

# MEMORY-BASED DIGITAL WORD SEQUENCE RECOGNIZER

## Technical Field

The present invention relates generally to circuits for recognizing digital word bit patterns, and in particular, to a memory-based circuit for recognizing the presence of a predetermined sequence of digital words included within a stream of digital words.

## Background of the Invention

The detection of the presence of a predetermined digital word sequence in a stream of digital words heretofore has been accomplished by circuits which include a plurality of similar memory-based subcircuits. Such circuits generally are incorporated in test equipment, such as a logic analyzer, which is used to troubleshoot and maintain digital circuitry. Each subcircuit receives at its address terminals a stream of digital information words from which the sequence is recognized. These digital words typically provide datum or address information from the circuit under test. Each memory-based subcircuit is included to recognize a predetermined digital word located at a particular position in the information word sequence. The number of subcircuits included in the circuit, therefore, determines the maximum detectable word sequence length.

A predetermined digital word can include "don't care" bits which provide a number of different possible information word bit patterns that may be recognized as the digital word sought to be detected at the particular position in the word sequence. In addition, some circuits include control subcircuits which have the capability for recognizing multiple contiguous occurrences of a particular information word in the sequence, thereby to provide an effective increase the maximum detectable word sequence length.

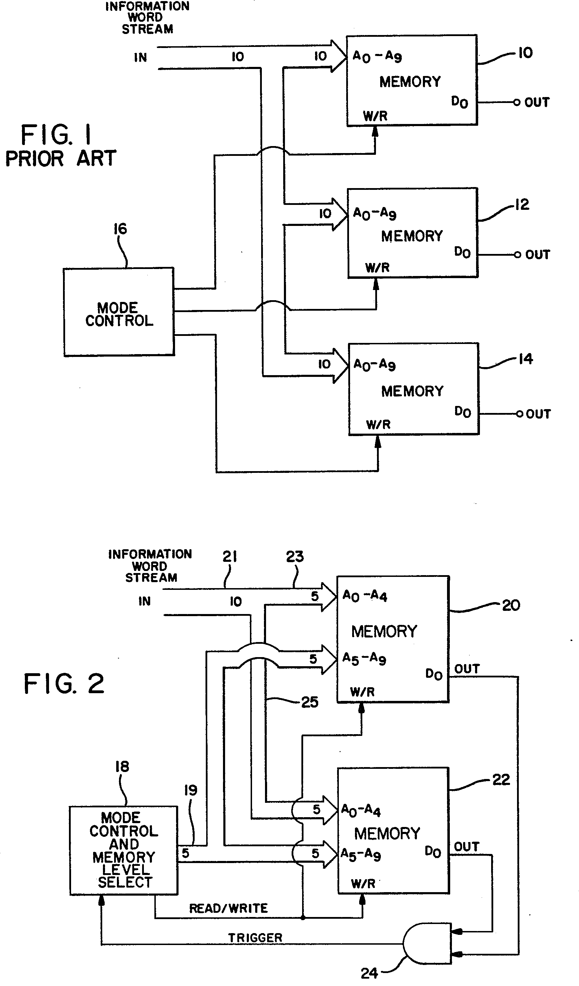

Fig. 1 is a simplified block diagram of an exemplary prior art circuit which incorporates the prior technique of accomplishing digital word sequence recognition. Each digital word included in the information word stream has a maximum number of ten parallel bits which are applied to address terminals $A_0$-$A_9$ of each of the three memory devices 10, 12, and 14 shown. Each memory device represents the position of a predetermined word in the sequence and is programmed to recognize a particular parallel bit pattern or bit patterns applied at the address terminals and sought to be detected.

The memory device included in each of the three subcircuits is typically a random access memory (RAM) which is programmed with bit pattern recognition information in each address memory location. Thus, for example, the bit pattern or patterns of the information word sought to be detected by a specified memory device would address a particular memory location programmed in a logic 1 state, and the bit patterns of information words not sought to be detected would address memory locations programmed in the logic 0 state.

The mode control circuit 16 applies a separate strobe signal to the WRITE/READ (W/R) input of each memory device. To detect a particular word in the sequence, a strobe signal which takes on the logic state that enables the memory READ mode is applied to the memory device programmed to recognize the particular word in the sequence. As the stream of information words having randomly varying parallel bit patterns is applied to each memory or subcircuit, the pattern recognition information in the logic 1 state appears at the $D_O$ output of the READ enabled memory device in response to the application of the desired information word bit pattern to its memory address terminals. The $D_O$ outputs of the other two memory devices not in the READ mode remain in the logic 0 state.

If more than one memory device is strobed to the READ mode, a logic OR operation indicating the occurrence in the sequence of either of two information words can be accomplished by applying the $D_O$ outputs to the inputs of a logic OR gate. For example, the occurrence in the sequence of either a word A or a word B can be detected by simultaneously strobing READ commands to the appropriate subcircuits having memory devices programmed to recognize word A and word B. A logic 1 state will appear at the output of the memory device corresponding to the word which occurs first in the information stream, irrespective of the order of appearance of that word in any particular sequence. Thus, the prior art circuit configuration can be used to accomplish certain nonsequential word recognition functions.

It is apparent that the use of the circuits embodying the prior technique of sequence recognition is practical for recognizing only very short sequences of digital words because of the number of memory devices required. A circuit of this design can generally be used, however, in conjunction with control circuits which apply memory READ strobe signals to more than one of the memory-based subcircuits to perform pattern recognition functions unrelated to the sequential occurrence of the digital words.

In addition, each subcircuit requires the use of memory devices which have a number of address terminals equal to the number of parallel bits of the largest digital word in the digital word stream. Thus, each subcircuit includes a memory device of substantial memory capacity sufficient to accommodate all possible permutations of the parallel bits in the largest information word.

## Summary of the Invention

One object of this invention is to provide a memory-based circuit for detecting the presence of a digital word sequence including a plurality of information words within a stream of digital words in a simple, efficient, and accurate manner.

Another object of this invention is to provide such a circuit having substantially fewer memory devices to detect long sequences of digital words with relatively large numbers of parallel bits.

A further object of this invention is to provide such a circuit which comprises a memory that is subdivided into a plurality of memory levels, with each such memory level corresponding to the position of a word in the information word sequence and including memory locations to store a recognition status word corresponding to the bit pattern or patterns sought to be detected of the word in the particular sequence position.

Still another object of this invention is to provide in a logic analyzer such a circuit to accomplish detection of digital word sequences with the use of substantially less memory capacity.

The present invention relates to a memory-based circuit which can be included in digital circuit test equipment, such as a logic analyzer, to detect the presence of a digital information word sequence within a stream of digital information words. The circuit comprises a memory means having address terminals and including a plurality of memory levels, each memory level having a plurality of memory locations. A first memory addressing means addresses the memory levels and includes at least one of the address terminals. The address terminals of the first addressing means are responsive to a memory level selection word to select a corresponding memory level to enable the writing of digital logic information into or the reading of digital logic information out of the memory locations included within the selected memory level. A second memory addressing means addresses the memory locations of each memory level and includes at least some of the remaining address terminals to respond to the bit pattern of each one of the words included in the stream of digital information words to address within the selected memory level a memory location corresponding to each one of the words. The circuit further comprises means to write pattern recognition information into the memory location addressed by the first and second addressing means. The pattern recognition information includes a recognition status word to indicate whenever there exists a

- 6 -                    0124238

correspondence between any one of a first predetermined number of bit patterns sought to be detected and the bit pattern of a word in the information word stream. The circuit includes means to read the pattern recognition information out of the memory location addressed by the first and second addressing means. A memory level control means which provides the memory level selection word communicates with the first addressing means to select a succeeding memory level in response to readout of the recognition status word from the memory location to enable detection of a correspondence between any one of a second predetermined number of bit patterns sought to be detected and the bit pattern of a succeeding word in the information word stream.

The differences between the design concepts underlying the circuits incorporating the prior art sequence recognition technique and those of the present invention may be discerned by way of comparison of the circuits shown in Figs. 1 and 2. The discussion of the memory architecture and operation of the circuit shown in Fig. 2 is presented in the Detailed Description of Preferred Embodiments hereinbelow.

As was stated earlier, the prior art circuit shown in Fig. 1 is capable of recognizing a digital word sequence of three words in length with each word having a maximum number of ten parallel bits. The exemplary circuit shown in Fig. 2 embodying the present invention, however, is capable of recognizing an information word sequence of thirty-two words in length with each word having a maximum number of ten parallel bits. Thus, recognition of the substantially longer sequence having digital words of the same length is accomplished by the circuit of Fig. 2 with the use of fewer memory devices than the circuit of Fig. 1 embodying the prior art sequence recognition technique which is capable of detecting a sequence of only three words in length.

Additional objects and advantages of the present invention will be apparent from the following detailed description of preferred embodiments thereof which proceeds with reference to the accompanying drawings.

Brief Description of the Drawings

Fig. 1 is a simplified block diagram showing the memory device arrangement in a prior art digital word sequence circuit for detecting a three word sequence having a maximum word length of ten parallel bits.

Fig. 2 is a simplified block diagram showing the memory device arrangement in one embodiment of a digital word sequence recognition circuit in accordance with the present invention for detecting a thirty-two word sequence having a maximum word length of ten parallel bits.

Fig. 3 is a block diagram of another embodiment of the digital word sequence recognition circuit of the present invention.

Detailed Description of Preferred Embodiments

With reference to the circuit shown in Fig. 2, five parallel signals at output 19 of mode control and memory level select circuit 18 are applied to the five address terminals $A_5$-$A_9$ of each memory device 20 and 22 to select the memory levels. The ten information word bits applied to ten parallel inputs 21 are divided into two equal groups of five parallel bits each on two sets 23 and 25 of five parallel conductors. Each group of five bits is applied to the remaining five address terminals

$A_0$-$A_4$ of a different one of the two memory devices 20 and 22 to select the memory locations included within the memory levels. Thus, applying the five bit memory level selection word to address terminals $A_5$-$A_9$ of both devices divides the memory into $2^5$ or thirty-two levels. Applying one of the two groups of five bits of the information word to address terminals $A_0$-$A_4$ of each memory device provides each memory level within each device with $2^5$ or thirty-two memory locations. Each memory device receives the same READ enable strobe signal at its W/R input from the WRITE/READ output of mode control 18.

During a word recognition operation, memory devices 20 and 22 are strobed to the READ mode. The $D_O$ output of each memory device is connected to a different input of an AND gate 24 and responds with a logic 1 state whenever the five bit pattern sought to be detected by such memory device is present at its memory address terminals $A_0$-$A_4$. A logic 1 state present coincidentally at the $D_O$ outputs of both memory devices indicates that there exists a one-to-one correspondence between each bit of the ten bit information word and each corresponding bit of the composite bit pattern or patterns which the two memory devices are programmed to recognize. When a logic 1 state appears coincidentally at both $D_O$ outputs, a logic 1 state is produced at the output of AND gate 24 to trigger the mode control and memory level select circuit 18. Circuit 18 responds to the recognition of the desired word in the designated position in the sequence by providing the memory level select word corresponding to the next succeeding word in the sequence. Thus, each memory level corresponds to a different position of each predetermined word in the information word sequence. A maximum number of thirty-two memory levels is obtainable, each memory level having the capability of recognizing a ten parallel bit information word.

The circuit in one embodiment of the present invention is directed, therefore, to the piecewise comparison of the bit patterns of the information word in a stratified memory architecture, with the outputs of the addressed memory locations in the selected memory level being logic AND'ed to determine whether the desired bit pattern is present and to address the memory devices to the next succeeding memory level. Since all memory devices are strobed in the READ mode simultaneously, the circuit is useful for detecting digital word sequences only. On the other hand, the circuits embodying the prior art technique of Fig. 1 utilize one memory device for each word in the sequence, but each memory device may be separately strobed to detect other than sequential word occurrences.

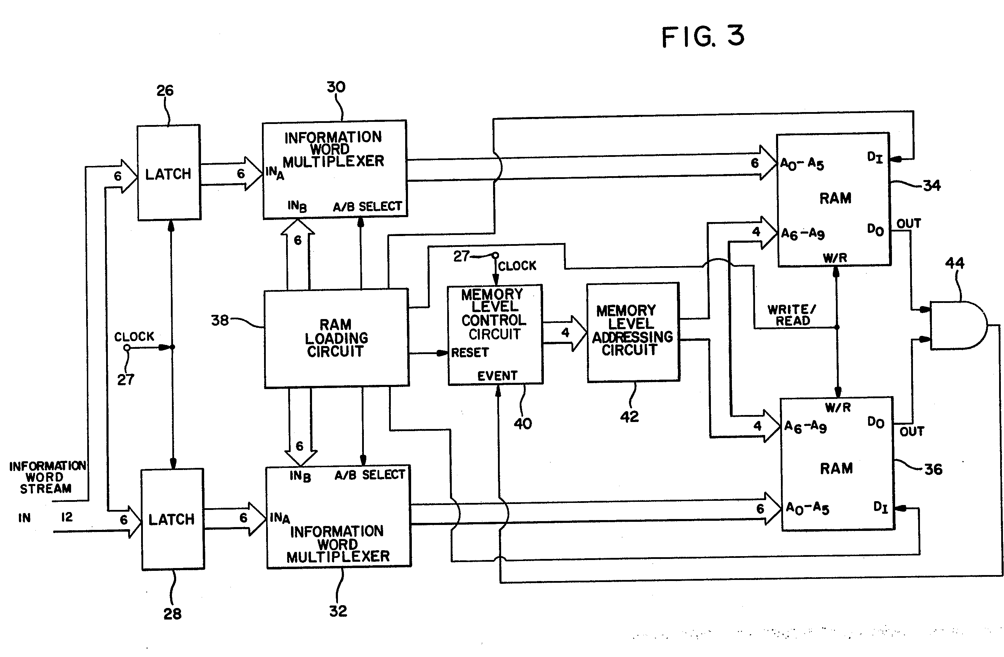

With reference to Fig. 3, a digital word sequence recognizer circuit designed in accordance with the present invention has the capability of detecting an information word sequence having at most sixteen contiguous nonredundant digital words. The word sequence is included in an information word stream which is comprised of a serial stream of digital words having twelve parallel bits which are applied to the input terminals of two latch circuits 26 and 28. Six of the twelve bits are applied to the input terminals of latch circuit 26, and the remaining six bits are applied to the input terminals of latch circuit 28. Latch circuits 26 and 28 are included to synchronize the logic transitions occurring on each of the twelve parallel bit input conductors to the negative-going edge of the system clock which is applied at clock input 27 to each latch circuit. All of the digital logic components included in the circuit of Fig. 3 are preferably of the emitter-coupled logic family, which provides very short logic state transition times to accomplish circuit operation at very high bit rates.

The six bits of the information word are clocked out of latch 26 and applied to input $IN_A$ of information word multiplexer 30, and the remaining six bits of the information word are clocked out of latch 28 and applied to input $IN_A$ of information word multiplexer 32. The six parallel outputs of multiplexers 30 and 32 are applied to address terminals $A_0$-$A_5$ of two random access memory (RAM) devices or means 34 and 36, respectively. It should be noted that any six of the ten memory address terminals can be used to receive the output lines from the multiplexers. Therefore, the selected address terminals of each RAM device are identified with reference nomenclature (e.g., $A_0$-$A_5$) for purposes of clarity only.

The $IN_B$ inputs of multiplexers 30 and 32 each receive one of two segments of a twelve parallel bit loading word from RAM loading circuit 38, with each loading word segment having six parallel bits corresponding to those provided by the outputs of latches 26 and 28, respectively. RAM loading circuit 38 provides a common signal to the A/B SELECT input of each multiplexer 30 and 32. The logic state of this signal determines the source of digital word bits which are applied to address terminals $A_0$-$A_5$ of RAMs 34 and 36. The information word bits applied to the $IN_A$ inputs of the multiplexers are applied to address terminals $A_0$-$A_5$ of RAMS 34 and 36 during the memory READ mode when pattern recognition information previously programmed into memory is read out at the data out $D_O$ outputs of RAMs 34 and 36. The loading word bits applied to the $IN_B$ inputs of the multiplexers are transmitted to address terminals $A_0$-$A_5$ of RAMS 34 and 36 during the memory WRITE mode when pattern recognition information is applied by the RAM loading circuit 38 to the data in $D_I$ inputs of and read into RAMs 34 and 36.

Memory level control circuit 40 provides a four parallel bit memory level selection word to the input terminals of memory level addressing circuit 42. The four parallel outputs of circuit 42 are applied to four memory address inputs $A_6$-$A_9$ of both RAMs 34 and 36. A particular bit pattern of the memory level address output signal applied to address terminals $A_6$-$A_9$ of each RAM selects one of a maximum possible number of $2^4$ or sixteen memory levels, with each memory level having a maximum possible number of $2^6$ or sixty-four memory locations addressed by six bits of the information word. Thus, memory level addressing circuit 42 comprises a first memory addressing means to address the memory levels of RAMs 34 and 36, and multiplexers 30 and 32 comprise a second memory addressing means to address the memory locations included within each memory level.

Each memory location in each memory level of the RAMs has a storage capacity of one bit. In the particular embodiment described herein, two bits of pattern recognition information are required to specify whether a particular twelve bit information word pattern applied to the $A_0$-$A_5$ address inputs of RAMs 34 and 36 is sought to be detected by a particular memory level.

In the memory WRITE mode, RAM loading circuit 38 delivers the WRITE signal to the W/R inputs and the pattern recognition information to the $D_I$ inputs of the RAMs. Circuit 38 also provides the loading word bits to the $A_0$-$A_5$ address inputs of the RAMs to write the pattern recognition information into the memory location addressed by the loading word. One bit of the pattern recognition information to be written into the memory location addressed by the six bits applied to input $IN_B$ of multiplexer 30 is applied to the $D_I$ input of RAM 34, and the other bit of the pattern recognition information to be written into the memory location addressed by the six bits applied to input $IN_B$ of multiplexer 32 is applied to the $D_I$ input of RAM 36. The pattern recognition information and loading words delivered to the RAMs by circuit 38 are produced by a peripheral source of software which is programmed to match the desired pattern recognition information with the corresponding loading word which addresses the memory location in a predetermined memory level.

In the memory READ mode, the six bits originating from the output of latch 26 are transmitted through multiplexer 30 and are applied to address terminals $A_0$-$A_5$ of RAM 34, and the six bits originating from the output of latch 28 are transmitted through multiplexer 32 and are applied to address terminals $A_0$-$A_5$ of RAM 36.

The $D_O$ output of each RAM 34 and 36 is applied to a different input of AND gate 44, the output of which is connected back to the EVENT input of memory level control circuit 40. To produce a logic 1 state at the output of AND gate 44, a logic 1 state must appear coincidentally at each input of AND gate 44. A logic 1 state appears at the $D_O$ output of each RAM whenever the address of the memory location in the predetermined memory level corresponds to the bit pattern of the six bit segment of the information word sought to be detected by the particular RAM. Thus, a logic 1 state programmed into a memory location constitutes a one bit recognition status word which indicates that the bit pattern of the information word segment applied at the RAM address terminals corresponds to a bit pattern sought to be detected.

Whenever both groups of six bits applied to address terminals $A_0$-$A_5$ of RAMs 34 and 36 coincidentally address memory locations which are programmed in the logic 1 state, thereby providing simultaneously a logic 1 state at each $D_O$ output, the output of AND gate 44 provides a logic 1 signal indicating the occurrence of the event of recognizing that a particular word in the information stream has the bit pattern for which the selected memory level was programmed to detect. In response to this event, the AND gate output triggers control circuit 40 which communicates this event to addressing circuit 42 which then selects in the manner described hereinbelow the succeeding memory level for continuing the sequence recognition operation. During the sequence recognition operation, a memory READ signal provided by circuit 38 is applied to the W/R inputs of each RAM for reading out the contents of the memory location at output $D_O$.

Memory level control circuit 40 produces a four parallel bit memory level selection word which is applied to the input terminals of memory level addressing circuit 42. Addressing circuit 42 is responsive to the memory level selection word bit

0124238

pattern to apply the appropriate address signals to memory level address inputs $A_6$-$A_9$ of RAMs 34 and 36. Depending upon the desired relationship between the memory levels and the information words in the sequence, selection of the memory level can be accomplished by means of either one of two methods.

A first method entails assigning each memory level to a particular position of a word in the sequence and is explained by way of example with reference to Table I.

0124238

| | 1 | 2 | 3 |
|---|---|---|---|
| | Information Word in the Sequence | Sequence Position of Information Word | Memory Level Selection Address $A_6$-$A_9$ of RAMs 34 and 36 |
| 1 | A | 1 | 0000 |
| 2 | B | 2 | 0001 |
| 3 | C | 3 | 0010 |
| 4 | D | 4 | 0011 |
| 5 | E | 5 | 0100 |
| 6 | F | 6 | 0101 |
| 7 | G | 7 | 0110 |
| 8 | H | 8 | 0111 |
| 9 | I | 9 | 1000 |
| 10 | J | 10 | 1001 |
| 11 | K | 11 | 1010 |
| 12 | L | 12 | 1011 |
| 13 | M | 13 | 1100 |
| 14 | N | 14 | 1101 |
| 15 | O | 15 | 1110 |
| 16 | P | 16 | 1111 |

TABLE I

Word Sequence: A B C D E F G H I J K L M N O P

Sequence Position 1    Sequence Position 8    Sequence Position 16

In Table I, the sequence includes sixteen contiguous nonredundant information words represented by a different alphabetic letter (Column 1). The position of each word (Column 2) in the sequence is represented by a different memory level selection word (Column 3). Thus, the memory level selection word 0000 corresponds to information word A in the first position of the sequence, memory level selection word 0001 corresponds to information word B in the second position of the sequence, and so on. The bit pattern or patterns of the information word in the particular position in the sequence represent the bit patterns applied to address terminals $A_0$-$A_5$ of RAMs 34 and 36 to select the particular memory locations into which a logic 1 state is programmed. During a sequence recognition operation, whenever there exists a correspondence between the bit pattern of the information word and that of the bit pattern sought to be detected, the logic 1 state stored in the addressed memory location simultaneously appears at the $D_0$ output of each RAM to cause a logic 1 state to appear at the output of AND gate 44. The output of AND gate 44 delivers a signal to the EVENT input of circuit 40 to furnish the next succeeding memory level selection word to address inputs $A_6$-$A_9$ of RAMs 34 and 36 to address the memory level corresponding to the next succeeding position in the word sequence.

Actual implementation of this first method includes the use of a four bit binary counter within control circuit 40. The output of the four bit binary counter can provide sixteen different digital word patterns, each such pattern having a one-to-one correspondence with a particular four bit word applied to memory level address terminals $A_6$-$A_9$

of RAMs 34 and 36.

A count pattern at the output of the binary counter provides a convenient means for assigning memory level words to particular word positions in the word sequence. Thus, as shown in Table I, count 0000 corresponds to word position 1 in the sequence; count 0001 corresponds to word position 2 in the sequence, etc. In this first method, addressing circuit 42 serves as an interface buffer between the four parallel bit output of memory level control circuit 40 and address terminals $A_6$-$A_9$ of RAMs 34 and 36.

Whenever a logic 1 state appears coincidentally at the $D_O$ outputs of RAMs 34 and 36, the output of AND gate 44 changes to a logic 1 state to provide a word recognized signal to the EVENT input of circuit 40. This word recognized signal is applied to the clock input of the binary counter within circuit 40 to toggle the counter to the next succeeding count, thereby to address RAMs 34 and 36 to the next succeeding memory level. Prior to the start of a word sequence recognition operation, RAM loading circuit 38 provides a signal to the RESET input of circuit 40 to initialize the output of the binary counter to count 0000, thereby to address the memory level in RAMs 34 and 36 corresponding to word position 1 in the sequence.

An alternative method for establishing a relationship between the memory levels and the information words in the sequence is described by way of example with reference to Table II.

| | 1 | 2 | 3 | 4 |
|---|---|---|---|---|
| | Information Word in the Sequence | Sequence Position of Information Word | Count Pattern of Binary Counter in Circuit 40 | Memory Level Selection Address $A_6$-$A_9$ of RAMs 34 and 36 |
| 1 | I | 1 | 0000 | 1000 |
| 2 | A | 2 | 0001 | 0000 |
| 3 | J | 3 | 0010 | 1001 |
| 4 | B | 4 | 0011 | 0001 |
| 5 | K | 5 | 0100 | 1010 |
| 6 | C | 6 | 0101 | 0010 |
| 7 | L | 7 | 0110 | 1011 |
| 8 | D | 8 | 0111 | 0011 |
| 9 | M | 9 | 1000 | 1100 |
| 10 | E | 10 | 1001 | 0100 |
| 11 | N | 11 | 1010 | 1101 |
| 12 | F | 12 | 1011 | 0101 |
| 13 | O | 13 | 1100 | 1110 |
| 14 | G | 14 | 1101 | 0110 |
| 15 | P | 15 | 1110 | 1111 |
| 16 | H | 16 | 1111 | 0111 |

TABLE II

Word Sequence: I A J B K C L D M E N F O G P H

Sequence Position 1

Sequence Position 8

Sequence Position 16

This alternative method entails programming into the memory locations included within a predetermined memory level the pattern recognition information corresponding to the bit pattern or patterns of a particular word which will appear in the sequence, irrespective of the position of that word in the sequence.

The sequence shown in Table II, for example, has sixteen contiguous nonredundant words, each word being represented by a different alphabetic letter (Column 1) and assigned to a predetermined memory level. The memory locations of each memory level are programmed with the appropriate pattern recognition information to recognize the desired bit pattern or patterns of the information word that will be presented to address terminals $A_0$-$A_5$ of RAMs 34 and 36. The bit pattern or patterns of information word A in the sequence are recognized by means of pattern recognition information stored in the memory locations of memory level address 0000 (line 2); the bit pattern or patterns of information word B in the sequence are recognized by means of pattern recognition information stored in the memory locations of memory level address 0001 (line 4), etc. The position of each information word in the sequence (Column 2) is stored in a memory means included within addressing circuit 42, the output of which applies the appropriate address information to address terminals $A_6$-$A_9$ of RAMs 34 and 36 (Column 4) to select the corresponding memory level. Thus, when the bit pattern of word I (line 1) in sequence position 1 is sought to be recognized, the bit pattern 1000 is provided by the output of circuit 42 to address terminals $A_6$-$A_9$ of RAMs 34 and 36; when the bit pattern of word A (line 2) in sequence position 2 is sought to be recognized, the bit pattern 0000 is provided by the output of circuit 42 to address terminals $A_6$-$A_9$ of RAMs 34 and 36, etc.

In the implementation of this alternative method, a four bit binary counter is also included within circuit 40. The four parallel bit output of such counter is applied to the four address terminals of the memory means included within addressing circuit 42. As was stated earlier, the memory included within addressing circuit 42 is programmed with the desired information word sequence. Thus, the count pattern (Column 3) provided at the output of the binary counter included in circuit 40 corresponds to the word position (Column 2) in the sequence. The binary counter output (Column 3) provides the signal which addresses a memory location in the memory of circuit 42, which memory is programmed with the appropriate memory level address (Column 4) to direct RAMs 34 and 36 to the corresponding memory level. The memory locations of such memory level are programmed with pattern recognition information to recognize the bit pattern or patterns specified by the particular word in the sequence. It should be noted that the memory means within circuit 42 includes a four parallel bit output to read out the contents of each memory location thereof. Circuit 42 also includes means (not shown) to load into its memory means the addresses to be provided to terminals $A_6$-$A_9$ of RAMs 34 and 36 in the proper order corresponding to the particular word sequence. The function of AND gate 44 in response to recognition of the desired information word is the same as that described for the first method of memory level selection.

Although the circuit operation described for the two methods of memory level selection has been directed to a sixteen word sequence having contiguous nonredundant words, the effective length of a sequence sought to be recognized can be increased by employing a control circuit which has, in addition to the previously described functions of circuits 40 and 42, the capability of recognizing multiple contiguous occurrences of a particular word. Such a circuit could employ, for example, the circuit and techniques disclosed in the copending patent application Serial No. 404,193, filed August 2, 1982, in the name of Kentaro Takita. The disclosure set forth in the Takita patent application describes a circuit utilizing a RAM in cooperation with a divide-by-N counter to detect multiple occurrences of a particular word. The subject matter set forth in the Takita patent application is incorporated by reference herein.

A control circuit incorporating the techniques disclosed in the Takita patent application would permit an increase in the maximum number of words in the sequence to equal the sum of the maximum possible number of memory levels and the number of contiguous redundant information words in the sequence. Thus, for example, a sequence with an information word appearing in the first position and repeated twice immediately thereafter has a contiguous redundancy of two. If this be the only contiguous redundancy in the sequence, a word recognizer having sixteen memory levels and incorporating a control circuit having the capability for recognizing contiguous redundancies could recognize the eighteen information words in the sequence.

- 22 -

0124238

With reference to Table III, the operation of the sequence recognizer is demonstrated by way of example.

| 1<br>Word Level<br>Address<br>$A_6$-$A_9$ of<br>RAMs 34 and 36 | 2<br>Word Bit<br>Pattern Address<br>$A_0$-$A_5$ of<br>RAM 36 | 3<br>Word Bit<br>Pattern Address<br>$A_0$-$A_5$ of<br>RAM 34 | 4<br>$D_0$ Output<br>of RAM 36 | 5<br>$D_0$ Output<br>of RAM 34 | 6<br>Word Recog-<br>nized Out-<br>put of AND<br>Gate 44 |
|---|---|---|---|---|---|
| 1 | 0000 | 000000 | 000000 | 0 | 0 | 0 |
| 2 | 0000 | 000000 | 000001 | 0 | 0 | 0 |
| 3 | 0000 | 000000 | 000010 | 0 | 1 | 0 |
| 4 | 0000 | 000000 | 000011 | 0 | 1 | 0 |
| 5 | 0000 | 000000 | 000100 | 0 | 0 | 0 |
| | . | . | . | . | . | . |
| 6 | 0000 | 000001 | 000000 | 1 | 0 | 0 |
| 7 | 0000 | 000001 | 000001 | 1 | 0 | 0 |
| 8 | 0000 | 000001 | 000010 | 1 | 1 | 1 |
| 9 | 0001 | 000001 | 000011 | 0 | 0 | 0 |

|  | | $A_0$-$A_5$ (RAM 36) | $A_0$-$A_5$ (RAM 34) |
|---|---|---|---|
| Level 0000 | Word A Bit Pattern: | 000001 | 00001X |
| Level 0001 | Word B Bit Pattern: | 000000 | 100000 |

X = "don't care" bit

TABLE III

- 24 -

0124238

Table III shows the bit patterns of information words sought to be detected in the first two positions in a hypothetical word sequence. Word A is assigned to memory level 0000 of RAMs 34 and 36 and has the parallel bit pattern shown below.

Word A: 00000100001X

The symbol "X" represents a "don't care" bit, which means that recognition of word A is accomplished by the appearance of either one of the following parallel bit patterns:

000001000010

000001000011

The number of "don't care" bits in the information word specifies the number of bit patterns sought to be detected and equals $2^X$, where X equals the number of "don't care" bits.

Word B is assigned to memory level 0001 and has the parallel bit pattern shown below.

Word B: 000000100000

Table III sets forth in columns 1-3 the logic states applied to the address terminals of RAMs 34 and 36; in columns 4 and 5 the pattern recognition information appearing at the $D_0$ output of each of the RAMs 36 and 34, respectively; and in column 6 the word recognized output signal of AND gate 44.

During a memory recognition operation, the twelve parallel bits of the information words are transmitted to address terminals $A_0$-$A_5$ of RAMs 34 and 36. Memory level control circuit 40 provides the memory level selection word having four parallel bits which are transmitted through memory level addressing circuit 42 to address terminals $A_6$-$A_9$ of RAMs 34 and 36, and RAM loading circuit 38 applies a READ signal to the W/R input of each RAM to enable readout of RAMs 34 and 36. For purposes of clarity, it is assumed that the serial bit pattern occurring in the information word stream is a binary count pattern; therefore, at the start of the sequence recognition operation, logic 0 states are applied to each one of address terminals $A_0$-$A_5$ of both RAMs 34 and 36. It is also assumed that memory level control circuit 40 provides a signal to circuit 42 so that its output addresses memory level 0000 of each RAM.

As was stated earlier, the pattern recognition information corresponding to each address bit pattern is shown for each of the RAMs 36 and 34 in columns 4 and 5, respectively, of Table III. It will be noted that the least significant bit position of word A includes a "don't care" state, thereby providing word A with either one of two ($2^1$) possible bit patterns which are sought to be detected. The bit pattern of word B includes no "don't care" bit positions; therefore, it is uniquely specified.

The digital logic states applied to address terminals $A_0$-$A_5$ of RAMs 34 and 36 are changed in accordance with the count pattern in synchronism with the negative-going edge of the clock. As shown on lines 3 and 4 of Table III corresponding to memory level 0000, the bit patterns 000010 and 000011, respectively, which are applied to word bit pattern address inputs $A_0$-$A_5$ of RAM 34 (Column 3), satisfy the conditions for detection of that segment of word A. Accordingly, in each instance, a logic 1 state appears at the $D_0$ output of RAM 34 (Column 5). The output of AND gate 44 (Column 6), however, remains in a logic 0 state because the bit pattern 000000 applied to bit pattern address inputs $A_0$-$A_5$ of RAM 36 (Column 2) at address memory level 0000 do not correspond with that segment of word A. As shown on line 5 of Table III, neither one of the bit patterns applied to address terminals $A_0$-$A_5$ of RAMs 34 and 36 matches the corresponding bit pattern segments of word A as the count pattern progresses; therefore, the $D_0$ outputs of RAMs 34 and 36 are in the logic 0 state.

As shown on line 6 of Table III, the logic states applied to inputs $A_0$-$A_5$ of RAMs 34 and 36 after the occurrence of the one-millionth negative-going clock edge provide a bit pattern 000001 to address terminals $A_0$-$A_5$ of RAM 36 (Column 2) which corresponds with that segment of word A. Accordingly, the $D_0$ output of RAM 36 (Column 4) changes to the logic 1 state. Since the bit pattern 000000 applied to address terminals $A_0$-$A_5$ of RAM 34 (Column 3) does not correspond to that segment of word A, the output of AND gate 44 remains in the logic 0 state.

As shown on line 8 of Table III, the word bit pattern 000001 applied to address terminals $A_0$-$A_5$ of RAM 36 (Column 2) and the word bit pattern 000010 applied to address terminals $A_0$-$A_5$ of RAM 34 (Column 3) address one of the two bit patterns of word A. This correspondence of both segments of one of the two desired bit patterns of word A causes the $D_0$ outputs of both RAMs to change coincidentally to the logic 1 state (Columns 4 and 5), thereby to provide a logic 1 state at the output of AND gate 44 (Column 6). The logic 1 state appearing at the AND gate output provides the signal to the EVENT input of memory level control circuit 40 to change the memory level control word to address the next succeeding memory level (level 0001) of RAMs 34 and 36. As shown on line 9 of Table III, neither one of the bit patterns applied to address terminals

$A_0$-$A_5$ of RAMs 34 and 36 matches the corresponding bit pattern segments of word B. Accordingly, the $D_O$ outputs of RAMs 34 and 36 return to the logic 0 state.

It will be appreciated by those skilled in the art that the circuit described hereinabove can be modified to accommodate shorter or longer word sequences by decreasing or increasing, respectively, the number of address terminals dedicated to address the memory levels. This would result in a corresponding decrease or increase in the number of bits in the memory level selection word.

Similarly, the maximum number of bits in an information word which can possibly be recognized by the circuit can be decreased or increased by decreasing or increasing, respectively, the number of address terminals dedicated to address the memory locations in a predetermined memory level.

An information word with a sufficiently small number of bits can be detected with the use of only one RAM in the circuit. Modifications to the circuit include elimination of AND gate 44, and the direct connection of the $D_O$ output of such one RAM to the EVENT input of memory level control circuit 40. To accommodate an information word with a very large number of parallel bits, additional RAM devices can be included to furnish the required additional bits. The parallel bits of the output of addressing circuit 42 are electrically connected to the address terminals of each additional RAM, and the $D_O$ output of each such RAM is applied to an additional input to the AND gate. The additional parallel bits of the information word are transmitted to the required number of remaining address terminals through latch circuits 26 and 28 and multiplexers 30 and 32 having the required number of input and output terminals.

By cascading additional memory devices in parallel with RAMs 34 and 36 and interconnecting them to share all corresponding address terminals and W/R input signal lines, it is possible to provide a sequence recognizer having a pattern recognition information output with more than one bit at several parallel $D_O$ outputs of the RAMs. In such a configuration, RAM loading circuit 38 would provide additional outputs to apply the desired pattern recognition information to the $D_I$ inputs of the added memory devices. The $D_O$ outputs of all RAMs would be applied to different inputs of AND gate 44. The pattern recognition information would comprise a number of parallel bits equal to the number of cascaded RAM devices.

It will be obvious to those having skill in the art that many changes may be made in the above-described details of the preferred embodiments of the present invention. The scope of the present invention, therefore, should be determined only by the following claims.

0124238

## CLAIMS

1. A multilevel memory-based circuit for detecting the presence of a digital information word sequence within a stream of digital information words, comprising:

memory means having address terminals and including a plurality of memory levels, each memory level having a plurality of memory locations;

first memory addressing means to address the memory levels, the first addressing means including at least one of the address terminals, the address terminals of the first addressing means being responsive to a memory level selection word to select a corresponding memory level to enable the writing of digital logic information into or the reading of digital logic information out of the memory locations included within the selected memory level;

second memory addressing means to address the memory locations of each memory level, the second addressing means including at least some of the remaining address terminals to respond to the bit pattern of each one of the words included in the stream of digital information words to address within the selected memory level a memory location corresponding to each one of the words;

means to write pattern recognition information into the memory location addressed by the first and second addressing means, the pattern recognition information including a recognition status word to indicate whenever there exists a correspondence between any one of a first predetermined number of bit patterns sought to be detected and the bit pattern of a word in the information word stream;

means to read the pattern recognition information out of the memory location addressed by the first and second addressing means; and

memory level control means to provide the memory level selection word, the control means communicating with the first addressing means to select a succeeding memory level in response to readout of the recognition status word from the memory location to enable detection of a correspondence between any one of a second predetermined number of bit patterns sought to be detected and the bit pattern of a succeeding word in the information word stream.

2. A circuit in accordance with claim 1 in which the memory level selection word corresponds to the position of at least one predetermined information word in the information word sequence, and the control means provides the memory level selection word corresponding to the next succeeding memory level in response to readout of the recognition status word.

3. A circuit in accordance with claim 1 in which the memory level selection word corresponds to the memory level wherein the bit patterns corresponding to a predetermined information word included in the information word sequence are stored, and the control means provides the memory level selection word corresponding to the next succeeding information word in the sequence in response to readout of the recognition status word.

4. A circuit in accordance with claim 1 in which the memory means comprises a random access memory.

5. A circuit in accordance with claim 1 in which the maximum number of memory locations in each memory level equals $2^N$, where N equals the number of bits in the information word.

6.  A circuit in accordance with claim 1 in which the first addressing means includes M number of address terminals and the second addressing means includes N number of the remaining address terminals, the address terminals of the first addressing means being responsive to the memory level selection words to provide at most $2^M$ memory levels and the address terminals of the second addressing means being responsive to the information words to provide at most $2^N$ memory locations in each memory level.

7.  A circuit in accordance with claim 1 in which the memory means comprises a plurality of memory devices, each device having the first addressing means including M number of address terminals, with each address terminal of one memory device being electrically connected to the corresponding address terminals of the other memory devices, and each device having the second addressing means which includes a plurality of the remaining address terminals;

and which also comprises a logic AND gate having the pattern recognition information of each memory device being applied to a different one of the AND gate inputs to produce a logic 1 state at the AND gate output upon coincidental correspondence between the bit pattern of a word in the information word stream and any one of the bit patterns sought to be detected, the control means being responsive to the logic 1 state at the AND gate output to control the first addressing means, thereby to provide an expanded memory means having a maximum possible number of $2^M$ levels, each level having a maximum possible number of $2^P$ memory locations, where P represents the sum of the address terminals of the

- 32 -     0124238

second addressing means of all the memory devices.

8. A circuit in accordance with claim 7 in which the information word comprises a maximum number of P bits.

9. A circuit in accordance with claim 1 in which the maximum possible length of the digital information word sequence which can be detected equals the sum of the maximum possible number of memory levels and the number of contiguous redundant information words in the sequence, each redundant information word including an information word having any one of the bit patterns sought to be detected in the addressed memory level.

10. A circuit in accordance with claim 1 in which the memory location storing the pattern recognition information comprises a one bit storage medium wherein one logic state of the pattern recognition information indicates that a desired information word bit pattern is applied to the second addressing means and the complementary logic state of the pattern recognition information indicates that an undesired information word bit pattern is applied to the second addressing means.

11. A circuit in accordance with claim 10 in which the memory means comprises a plurality of memory devices which are electrically interconnected to have the same number and arrangement of address terminals for the first addressing means and the same number and arrangement of address terminals for the second addressing means, thereby to provide the pattern recognition information with a plurality of parallel bits.

12. The circuit in accordance with claim 11 in which the number of the pattern recognition information parallel bits equals the total number of

- 33 -

0124238

memory devices.

13. In a logic analyzer having a multilevel memory-based circuit for detecting the presence of a digital information word sequence within a stream of digital information words, the improvement comprising:

memory means including address terminals, the address terminals being grouped to comprise a first memory addressing means to address memory levels and a second memory addressing means to address memory locations within each of the memory levels, the first addressing means including M number of the address terminals to receive a plurality of memory level selection words and the second addressing means including N number of the remaining address terminals to receive the stream of digital information words, the first and second addressing means providing a memory means having a maximum possible number of $2^M$ memory levels with each memory level having a maximum possible number of $2^N$ memory locations;

means to write pattern recognition information into the memory location addressed by the first and second addressing means, the pattern recognition information having a particular logic state to indicate whenever the bit pattern of a word included in the information word stream and received by the second addressing means corresponds to any one of a first predetermined number of bit patterns sought to be detected;

means to read the pattern recognition information out of a memory location addressed by the first and second addressing means, the pattern recognition information appearing at the output of the memory means; and

memory level control means communicating

0124238

with the first addressing means to provide a succeeding memory level selection word upon detection of a correspondence between the bit pattern of the information word and any one of a second predetermined number of bit patterns sought to be detected.

14. A logic analyzer in accordance with claim 13 in which the memory level selection word corresponds to the position of at least one predetermined information word in the information word sequence, and the control means provides the memory level selection word corresponding to the next succeeding memory level whenever the bit pattern of the predetermined information word corresponds to any one of the first predetermined bit patterns.

15. A logic analyzer in accordance with claim 13 in which the memory level selection word corresponds to the memory level wherein the bit patterns corresponding to a predetermined information word included in the information word sequence are stored, and the control means provides the memory level selection word corresponding to the next succeeding information word whenever the bit pattern of the predetermined information word corresponds to any one of the first predetermined bit patterns.

16. A logic analyzer in accordance with claim 13 in which the memory means is a random access memory.

17. A logic analyzer in accordance with claim 13 wherein for each addressed memory level, the predetermined number of bit patterns sought to be detected is established by the number of "don't care" bits in the information word bit pattern.

18. A logic analyzer in accordance with claim 13 in which the memory means comprises a plurality of memory devices, each memory device having the address terminals of the first and the second memory addressing means, the address terminals of the first addressing means of each memory device being electrically connected to the corresponding address terminals of all the other devices, and the address terminals of second addressing means of each memory device being independent of the address terminals of all the other devices;

and which also comprises a logic AND gate having each of its inputs electrically connected to the output of a different one of the memory devices and having its output in communication with the control means, the control means activating the first addressing means in response to the presence at the output of the AND gate of a logic 1 state which occurs upon the coincidence of the particular logic state of the pattern recognition information at the output of each memory device, thereby to provide an expanded memory means having $2^M$ maximum possible number of memory levels, each level having a maximum possible number of memory levels equal to $2^N$ times the total number of memory devices included in the memory means.

19. A logic analyzer in accordance with claim 13 in which the maximum possible length of the digital information word sequence which can be detected equals the sum of the maximum possible number of memory levels and the number of contiguous redundant information words in the sequence, each redundant information word including an information word having any one of the bit patterns sought to be detected in the addressed memory level.

0124238

1/2

FIG. 1
PRIOR ART

FIG. 2

# FIG. 3